Europäisches Patentamt

European Patent Office

Office européen des brevets

(11) Publication number: **0 546 560 A1**

## EUROPEAN PATENT APPLICATION

(21) Application number: **92121111.6**

(22) Date of filing: **11.12.92**

(51) Int. Cl.5: **H01B 1/22, C08K 3/08**

(30) Priority: **13.12.91 JP 352347/91**

(43) Date of publication of application:
**16.06.93 Bulletin 93/24**

(84) Designated Contracting States:
**DE FR GB**

(71) Applicant: **E.I. DU PONT DE NEMOURS AND COMPANY**
**1007 Market Street**
**Wilmington Delaware 19898(US)**

(72) Inventor: **Taylor, Barry Edward**
**2609 Mica Mine Lane**
**Wake Forest, North Carolina 27587(US)**
Inventor: **Tsuchiya, Motohiko**
**2-19-2-102 Naruse**
**Machida-shi, Tokyo 194(JP)**
Inventor: **Okabe, Chie**
**2-28-22-303 Sakuragaoka, Hodogaya-ku**
**Yokohama 240(JP)**

(74) Representative: **von Kreisler, Alek,**
**Dipl.-Chem. et al**
**Patentanwälte Von Kreisler-Selting-Werner,**
**Deichmannhaus am Hauptbahnhof**
**W-5000 Köln 1 (DE)**

(54) **Thick film copper paste composition.**

(57) A copper thick film paste composition comprising finely divided particles of copper metal in flake configuration dispersed in an organic medium comprising a solution of polymer and organic solvent.

EP 0 546 560 A1

## FIELD OF INVENTION:

The invention relates to thick film copper paste compositions. In particular, the invention relates to such pastes in which the copper is of flake configuration.

## BACKGROUND OF THE INVENTION:

Fired conductive thick film pastes have long been used for the formation of conductive patterns for the electrical connection of various electronic circuit components. Such pastes are comprised of finely divided particles of conductive metal, e.g., Ag, Ag/Pd, Au, Ag, Cu and the like, and usually a small amount of inorganic binder, both of which are dispersed in an organic medium comprising a normally solid organic polymer dissolved In a volatilizable solvent. When such pastes are fired to form a sintered conductive pattern of conductive metal, they must, however, have several attributes which are needed for practical application. For example, the resultant sintered metal pattern must be (1) highly conductive, (2) wettable to molten solder, (3) compatible with other circuit components, and (4) processable under a broad range of conditions. Copper thick film pastes are of particular interest because of the superior conductivity and low cost of copper metal.

Hybrid microcircuits have recently been required to meet increasing demands for miniaturization, for higher density wiring, and for higher density mounting, which has resulted in the extensive use of a through-hole printing process, comprising forming a plurality of conductor pattern layers and forming a conductor layer within the through-hole inner walls to connect these layers. Therefore, a copper conductor composition is required to form a conducting layer with good adhesion and stability when the through-hole inner wall is printed.

However, the usefulness of copper powder in thick film applications is significantly affected by the size and shape of the particles. That is, the size and shape of the particles are quite important with respect to achieving an adequate degree of adhesion to the substrate on which it is used, as well as solder wettability without adversely affecting the conductivity and density of the fired copper film.

Conventional copper conductor compositions using a copper powder which is nearly spherical in shape require that the copper metal particles be as small as possible in size for the purpose of thorough firing at a low firing temperature, thorough adhesion and generating a highly solder-wettable fired conductor layer. On the other hand, smaller copper powder particles, when used in a copper conductor composition printed on the baseboard, behave such that groups of particles generating a conducting network will shrink on drying at a relatively low temperature (120C) and firing at 500-1000C; this results in a tendency to generate cracks in the fired conductor layer. Obviously, a large particle-size copper powder will provide, upon firing, a copper film with a coarse density or will be inferior in solder-wettability and print characteristics.

For the above reasons, there remains a very substantial need for thick film copper pastes which are improved with respect to fired density and solder wettability while simultaneously meeting the requirements of conductors in terms of high electrical conductivity and adhesion, as well as suppressing the formation of through-hole cracks.

## SUMMARY OF THE INVENTION:

In its primary aspect, the invention is directed to a copper thick film conductive paste composition comprising finely divided particles of copper metal in flake configuration dispersed in an organic medium comprising a solution of polymer binder and organic solvent. In a preferred aspect the invention is directed to such a composition in which the copper flake particles are in admixture with non-flake copper particles, the weight ratio of non-flake to flake particles being from 0.05 to 0.9.

## PRIOR ART:

U.S. 4,521,329 Siuta et al.

Thick film conductor compositions comprising finely divided particles of copper oxide-coated copper and low softening point inorganic binder dispersed in a low-resin organic medium. Additional copper oxide is incorporated into the composition by either direct addition or by inclusion in the inorganic binder.

U.S. 4,540,604 Siuta

A copper-containing thick film conductor composition comprising a mixture of finely divided particles of (a) a conductive material containing copper metal, (b) inorganic binder, and (c) 0.2-5% wt. of a noncuprous metal selected from the group consisting of tungsten, molybdenum, rhenium and alloys and mixtures thereof all dispersed in organic medium. The metal particles must be within certain narrow ranges of particle size.

U.S. 4,687,597 Siuta

A fritless copper conductor composition suitable for overprinting on copper consisting essentially of (a) 10-50% wt. finely divided copper particles, (b) 90-50% wt. coarse copper particles, (c) 0.2-2% wt. reducible heavy metal oxide, (d) 0-1.0% refractory metal and (e) 0-5.0% of a high surface area noble metal, all the particles being dispersed in an organic medium.

U.S. Patent Application S.N. 07/749,161, Siuta

A method for making a thick film/solder joint comprising the sequential steps of (a) applying a layer of first thick film conductor paste to an electrically non-conductive substrate in a pattern which has preselected solder pad areas and firing the layer; (2) applying over the first thick film layer only within the solder pad area a layer of a second thick film conductor paste having a low frit content and firing the layer; and (3) forming the solder joint by applying to the fired second thick film layer a layer of soft solder.

DETAILED DESCRIPTION OF THE INVENTION:

The metal particles used in this invention are copper particles. It is important for the copper to have little oxide film and to be of high purity because such impurities tend to decrease the electrical conductivity and to interfere with the copper firing and the solder wettability of the copper film. This requirement is particularly important in the composition of the invention which requires developing copper particles with maximum electrical conductivity and which requires firing at a relatively low firing temperature (500-1000C), substantially below the melting point of the copper (1083C), in addition to the requirement of outstanding solder wettability.

Copper metal particles are available either nonflake or flake configuration. The flake powder may be of an irregular shape or of a spherical shape. As used herein, the term "flake copper metal particle" means a copper powder having an aspect ratio of 2.5-100 which is defined by the expression (L + W/2) (1/T), where L, W and T are dimensions in the three-dimensional coordinates of a flake copper metal particle as illustrated by Fig. 3.

The nonflake copper powder for use in the invention is preferably composed substantially of particles all of which are 10 $\mu$m or less. This is because particles greater than 10 $\mu$m will plug up the screen normally used in printing patterns of the paste. However, it is usually permissible to have large particles on the order of 5% by weight. Thus the above expression "substantially" means at least about 95% by weight.

Flake copper metal powder is selected in view of the fact that the gap between the particles which form an electrically conducting network state greatly affects the firing density of the composition. That is, the gap between the particles in the fired film of a composition depends on the recipe amount of copper flakes, the main particle size (the size of aggregate-free individual particles), the shape and structure of aggregates, the density and chemical phenomena on the metal surface; another important factor for the gap is the aspect ratio.

The aspect ratio for the flake copper used in this invention, in view of the gap between the particles, is defined as 2.5-100.

The flake copper used in this invention preferably has an average particle size (according to Fisher Sub-Sieve Sizer ASTM B330-82, hereafter called Fisher method), or a particle size according to an SEM micrograph observation, of 1-10 $\mu$m in average particle diameter. A flake copper having a greater average particle diameter than the above will result in either no paste formation or in a paste formation plagued with plugging up of the printing screen when it is screen printed with a 150-400 mesh screen.

The preferred thickness of the flake copper is in the range of about 0.1-0.4 $\mu$m because the optimum aspect ratio is 2.5-100, which is arrived at on the basis of the effect on the gap between the particles. There are no particular limitations as to the external shape, cross-sectional shape and size distribution for the flake copper.

The amount of copper flake used is at least 5% by weight on the basis of the total copper metal. This is needed simultaneously to meet the three required properties, the suppression of through-hole crack formation, good solder-wettability and the fired copper film density, as well as for meeting the required properties, high electrical conductivity and good adhesion that are inherent with a copper conductor. Clearly, if it is needed, all of the copper metal particles can be flake copper.

The copper metal particles used in this invention may have copper oxide on the surface section of the copper.

The composition of this invention, in addition to the above copper metal particles, may contain oxide particles from transition metals, such as copper, iron, nickel, cobalt, zinc, manganese and the like. These metal oxide particles may be present in amounts of up to 0.15 parts by weight per part of metal particles.

The inorganic binder used in this invention, including glass and other metal oxides mentioned above, performs several functions. The primary function of the binder is to give a chemical or mechanical bonding to the base material.

The inorganic binder is normally used in an amount up to 20% by weight, preferably 1-10% by weight of the total inorganic solids in the composition.

The above inorganic particles are mechanically mixed with an organic liquid medium (vehicle) to form a paste composition having a consistency and rheology suitable for processes, such as screen printing, drawing and dipping. The paste composition is coated onto a conventional base material as a thick film by the usual methods. Screen printing is preferred.

Any organic liquid can be used as the liquid medium so long as it is capable of cleanly volatilizing off during the drying and firing. A variety of liquids either with or without a concentrator and/or stabilizer, and/or other additives can be used in the organic medium. The organic liquids that may be used include, for example, aliphatic alcohols and esters of such alcohols, such as acetates and propionates; terpenes, such as wood turpentine oil, terpineol and others; resins such as a lower alcohol solution of polymethyl methacrylate; and a solvent [sic], for example, a solution of ethyl cellulose in wood turpentine oil and the monobutyl ether of ethylene glycol monoacetate. A preferred organic medium is based on ethyl cellulose and 2,24-trimethylpentane diol-1,3-monoisobutyrate. The vehicle may also contain a volatile liquid to accelerate a rapid drying after being applied to a base material.

It is preferred that the organic medium contain no resin at all. However, the organic medium must contain a suitably small amount of resin to permit a satisfactory application to permit the dispersion to develop suitable rheology for coating by the above mentioned methods.

The ratio of the organic medium with respect to solids in the composition of this invention can be appreciably varied, depending upon the methods by which the dispersion is applied and the type of organic medium used. For a good coating to be accomplished usually calls for the paste composition of this invention to contain complementally 20-95% by weight solids and 80-5% vehicle.

The recipe of the composition of this invention preferably uses a minimum amount of an organic medium as well as using a minimum amount of a polymeric material in the organic medium as discussed above. The reason for the two requirements is the need for complete evaporation of the organic medium used. The amount of oxygen which can be utilized for vaporizing off the organic medium is very limited because of the obvious need to fire the copper in a nonoxidizing environment. Therefore, the recipe for the composition should use as small an amount of resin as possible in controlling the rheology. Obviously, the composition of this invention can be modified by adding other materials which do not adversely affect the advantageous properties of the composition. Such recipes are practiced in the prior art.

The copper conductor composition of this invention is normally applied to a base material (substrate), for example, to an alumina ceramic material, by screen printing. The wet thickness should be about 10-80 $\mu$m, preferably 25-60 $\mu$m. The composition of this invention can be printed onto a substrate by the usual methods by means of an automatic printer or hand printer. Preferably, this is carried out by using an automatic screen stencil technique which uses a 150-400 mesh screen. The printed pattern is then dried at temperatures of not more than 200C, for example, 120-150C for about 5-15 minutes, followed by firing. The firing, for firing both the inorganic binder and the finely divided copper particles, is carried out preferably according to a temperature profile involving the combustion of organic matter at about 300C and heating up to 600C to make a thick film dense, either in a reducing or inert atmosphere in a belt oven. Then, in order to prevent the base material from undergoing breakage which might occur due to overfiring, or an unnecessary chemical reaction at an intermediate temperature, or too rapid a cooling, a controlled cooling cycle is implemented. The entire firing process preferably takes about one hour: 20-25 minutes until the peak firing temperature is reached, about 10 minutes at the firing temperature and about 20-25 minutes for cooling. In some cases, a short cycle totalling 30 minutes can be used.

EXAMPLES

Example 1

A conductor composition sample A was prepared by dispersing copper metal particles, 81.58% by weight of copper spheres, 1 $\mu$m in diameter and 3.05% by weight of copper oxide particles, together with 3.92% by weight of a lead borosilicate type amorphous glass inorganic binder in 11.45% by weight of a vehicle composed of a mixture of ethyl cellulose and terpineol.

Example 2

Sample 2 was prepared in a manner similar to that for Sample 1 except for replacing copper spheres of 1 $\mu$m in diameter with a 1:1 mixture of copper spheres, 1 $\mu$m in diameter and copper spheres 5 $\mu$m in diameter.

Sample 3 was prepared in a manner similar to that of Sample 1 except for replacing copper spheres of 1 $\mu$m in diameter with copper spheres 5 $\mu$m in diameter.

Sample 4 was prepared by using a mixture of 10% by weight of 1.7 $\mu$m flake copper and 90% by weight of copper spheres, 1 $\mu$m in diameter, as the copper metal particle component.

Sample 5 was prepared in a manner similar to Sample 4 except for replacing copper spheres 1 $\mu$m in diameter by a 1:1 mixture of copper spheres 1 $\mu$m in diameter and copper spheres 5 $\mu$m in diameter.

Sample 6 was prepared in a manner similar to that of Sample 4 except for replacing copper spheres 1 $\mu$m in diameter by copper spheres 5 $\mu$m in diameter.

Sample 7 was prepared using 20% by weight of 1.7$\mu$m flake copper and 80% by weight of a 1:1 mixture of copper spheres 1 $\mu$m in diameter and copper spheres 5 $\mu$m in diameter as the copper metal particle component.

Sample 8 was prepared using a mixture of 30% by weight of 1.7 $\mu$m flake copper and 70% by weight of copper spheres 1 $\mu$m in diameter as the copper metal particle component.

Sample 9 was prepared using a mixture of 50% by weight of 1.7 $\mu$m flake copper and 50% by weight of copper spheres 1 $\mu$m in diameter as the copper metal particle component.

Sample 10 was prepared in a manner similar to that of Sample 9, except for replacing the 1.7 $\mu$m flake copper by 3.9 $\mu$m flake copper.

Sample 11 was prepared in a manner similar to that of Sample 9, except for replacing the 1.7 $\mu$m flake copper by 2.3 $\mu$m flake copper.

Sample 12 was prepared using a mixture of 70% by weight of 1.7 $\mu$m flake copper and 30% by weight of copper spheres 1 $\mu$m in diameter as the copper metal particle component.

Sample 13 was prepared using 1.7 $\mu$m flake copper alone as the copper metal particle component.

Sample 14 was prepared similar to that of Sample 8 except for replacing the 1.7 $\mu$m flake copper by 3.9 $\mu$m flake copper.

Sample 15 was prepared in a manner similar to that of Sample 13 except for replacing the 1.7 $\mu$m flake copper by 2.3 $\mu$m flake copper.

Table 1 summarizes the composition and properties of the copper metal particles of Samples 1-15 copper metal particles.

Incidentally, 1.7 $\mu$m flake copper is one with an average particle diameter by the Fisher method of 1.7 $\mu$m which is 5 $\mu$m according to an SEM micrograph observation. The aspect ratio of 5-30. 3.9 $\mu$m flake copper is one with an average particle diameter by the Fisher method of 3.9 $\mu$m which is 8 $\mu$m according to an SEM micrograph observation. The aspect ratio is 2.5-7. 2.3 $\mu$m flake copper is one with an average particle diameter by the Fisher method of 2.3 $\mu$m which is 10 $\mu$m according to SEM micrograph observation. The aspect ratio is 2.5-10.

The glass used as the inorganic binder in the examples had a composition by weight of 69% PbO, 9% CdO, 9% $SiO_2$ and 13% $B_2O_3$.

The above described conductor compositions were evaluated and observed as to the extent of suppression of through-hole crack formation, solder-wettability and, for the SEM cross sections, density of the resultant fired paste layers.

The extent of suppression of through-hole crack formation was evaluated by a simple through hole experimental method in a simulation of through-hole printing with a thick film paste which permits predicting the actual frequencies with which the through-hole cracks are generated. That is, in actual operation, both sides of a substrate having a through-hole are printed with a thick film paste followed by firing. In such a case, cracks tend to form in areas where the printed films overlap on the inner wall of the through-hole.

Therefore, the simple experiment consisted of printing paste films to overlap each other on the baseboard, followed by observing the manner in which cracks were generated on the overlapped area as a means for predicting the occurrence of through-hole cracks. The following specific method was used:

1. Apply scotch tape with a gap of about 1 mm parallel to each other onto an alumina substrate;

2. Print the paste onto the gap using a scraper;

3. Peel off the tape and dry at 120C;

4. Again, apply tape to the dried printed paste shifting about 0.5 mm followed by printing in a similar manner;

5. Peel off the tapes and dry at 120C;

6. Fire at 600C in a nitrogen atmosphere.; and

7. Inspect for the occurrence of cracks on the fired portion.

The change in the number of tapes permits controlling the printed film thickness of the paste.

The following evaluation basis was used for monitoring the suppression of through-hole crack formation.

| No. of Tapes | No. of Tapes | Rating Basis |
|---|---|---|
| 1 No Crack Formation | 2-No Crack Formation | 1 (Good) |
| No Crack Formation | Small Cracks | 2 |
| No Crack Formation | Cracks | 3 |
| No Crack Formation | | 4 |
| No Crack Formation | | 5 (Poor) |

The following solder-wettability test procedure was used:

1. Screen print a copper paste onto an alumina baseboard.

2. Dry 10 minutes at 120C.

3. Fire at 600°C in a nitrogen atmosphere.

4. Place a drop of a mildly active type flux (Alpha Metal Co., Alpha 611) and place on top of it a 2 mm solder ball of a 63 Sn/37 Pb solder.

5. Preheat the above sample for 1 minute on a hot plate at 100-150C and immediately permit reflowing for 15 seconds on a 240C hot plate.

6. Allow the sample to cool and calculate the percent spreading of the solder ball according to the following equation:

(Percent Spreading) = (Diameter of the solder ball after reflow)-[Diameter of the ball before reflow (in this case 2 mm)]/(Diameter of the ball before reflow) x 100 (%)

The greater the percent spreading, the better the solder wettability.

An SEM observation was made in the following manner:

(1) Screen print a copper paste onto an aluminum baseboard.

(2) Dry for 10 minutes at 120C.

(3) Fire at 600C in a nitrogen atmosphere.

(4) Split the fired part and observe the cross section by SEM.

Table 1 summarizes the test results on the evaluation of suppression of through-hole crack formation; Table 2 shows the results on solder-wettability; and Table 3 shows the results of an SEM observation of the density of the copper films generated after firing.

Table 1

| Effect of Mixed Particle Configuration on Crack Formation | | | | | | | | | |
|---|---|---|---|---|---|---|---|---|---|
| Sample Nos. | Spherical Cu Particle Size (μm) | Proportions of Flake Copper (% Wt.) | | | | | | | Flake Cu Particle Size, μm |
| | | 0 | 10 | 20 | 30 | 50 | 70 | 100 | |
| 1-3 | 0.2 | 3 | 1 | 1 | - | - | - | - | 1.7 |
| 4-9 | 1 | 5 | 5 | - | 3 | 1 | 1 | 1 | 1.7 |
| 10, 11 | 1 | - | - | - | - | 1 | - | 1 | 3.9 |
| 12, 13 | 1 | - | - | - | - | 1 | - | 1 | 2.3 |
| 14-16 | 5 | 1 | 1 | 1 | - | - | - | - | 1.7 |

The data in Table 1 show that as the amount of flake copper is raised, crack formation is reduced.

Table 2

| Effect of Mixed Particle Configuration on Solder Wettability | | | | | | | | | |
|---|---|---|---|---|---|---|---|---|---|
| Sample Nos. | Spherical Cu Particle Size (μm) | Proportions of Flake Copper (% Wt.) | | | | | | | Flake Cu Particle Size, μm |
| | | 0 | 10 | 20 | 30 | 50 | 70 | 100 | |
| 1-3 | 0.2 | 103 | 107 | 113 | - | - | - | - | 1.7 |
| 4-9 | 1 | 114 | 124 | - | 118 | 136 | 133 | 135 | 1.7 |
| 10, 11 | 1 | - | - | - | - | 124 | - | 124 | 3.9 |
| 12, 13 | 1 | - | - | - | - | 155 | - | 123 | 2.3 |
| 14-16 | 5 | 49 | 92 | - | - | - | - | - | 1.7 |

The data in Table 2 show that as the amount of flake copper is raised, solder wettability is improved.

Table 3

| Effect of Mixed Particle Configuration on Film Density by SEM | | | | | | | | | |
|---|---|---|---|---|---|---|---|---|---|
| Sample Nos. | Spherical Cu Particle Size (μm) | Proportions of Flake Copper | | | | | | | (% Wt.) Flake Cu Particle Size, μm |
| | | 0 | 10 | 20 | 30 | 50 | 70 | 100 | |
| 1-3 | 0.2 | Good | Good | Good | - | - | - | - | 1.7 |
| 4-9 | 1 | Good | Good | - | Good | Good | Good | Good | 1.7 |
| 10, 11 | 1 | - | - | - | - | Good | - | Good | 3.9 |
| 12, 13 | 1 | - | - | - | - | Good | - | Good | 2.3 |
| 14-16 | 5 | Poor | Good | - | - | - | - | - | 1.7 |

The data in Table 3 show that as the amount of flake copper is raised, film density is improved. Furthermore, the data show that good film density can be obtained with either small non-flake particles or flake particles.

These results clearly demonstrate that the examples of this invention are superior in fired density, solder wettability and suppression of through-hole cracks compared to the control examples using the prior art nonflake copper metal powder alone. Such an effect is greatly attributed to the fact that the flake copper has a high density even during drying, with little change in density upon firing and shrinking.

There is a clear difference in the effect which depends on the size of the nonflake copper powder particles in a mixture of a nonflake copper powder and flake copper powder. A comparison of Samples 1, 4 and 14 or Samples 5, 2 and 15 shows that a sample containing a small particle size nonflake copper powder gives a smaller effect in suppressing crack formation, but gives a superior effect in terms of solder wettability and density compared to those with a large particle size.

There is also a clear dependence of the above three properties on increasing the percent by weight of the flake copper powder. In general, a greater ratio of the flake copper powder gives a more favorable result on the effect of suppressing crack formation; however, even with a composition containing 10% by weight of a flake copper powder, a good selection of the size of the nonflake copper powder used in combination can provide a preferred result. With respect to the solder wettability, in general, one with a greater amount of flake copper powder gives a preferred result. Good results on density is obtained on any sample as long as the amount of the flake copper powder is at least 10% by weight.

The copper conductor composition of this invention gives electrical conductivity essentially as good as that of the conventional copper conductor composition. As described above, the copper conductor composition of this invention retains the inherent characteristics of a copper conductor composition such as high electrical conductivity while improving firing density and solder wettability as well as suppressing the formation of through-hole cracks.

**Claims**

1. A copper thick film conductive paste composition comprising finely divided particles of copper metal in flake configuration dispersed in an organic medium comprising a solution of polymer binder and organic solvent.

2. The composition of claim 1 in which the copper flake particles are in admixture with non-flake copper particles, the weight ratio of non-flake to flake particles being from 0.05 to 0.9.

3. The composition of claim 1 which contains 1-20% by weight inorganic binder, basis total inorganic solids.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | US-A-4 884 754 (P.B.KEMP & AL) <br> * column 1, line 24 - line 68 * <br> * column 3, line 40 - line 44 * <br> --- | 1,2 | H01B1/22 <br> C08K3/08 |
| X | FR-A-2 286 160 (EATON,MANFORD LESLIE) <br> * page 10, line 18 - line 31; claims 1-12; example 4 * <br> --- | 1,2 | |
| X | US-A-4 247 594 (M.R.SHEA & AL) <br> * the whole document * <br> ----- | 1 | |

TECHNICAL FIELDS SEARCHED (Int. Cl.5 )

H01B
C08K

The present search report has been drawn up for all claims

| Place of search | Date of completion of the search | Examiner |
|---|---|---|
| THE HAGUE | 15 MARCH 1993 | DROUOT M.C. |

EPO FORM 1503 03.82 (P0401)